Europäisches Patentamt

European Patent Office

Office européen des brevets

(19)

(11) Publication number: **0 155 106 B1**

(12) **EUROPEAN PATENT SPECIFICATION**

(45) Date of publication of patent specification: **10.07.91**   (51) Int. Cl.⁵: **H01L 31/06, H01L 31/0376**

(21) Application number: **85301241.7**

(22) Date of filing: **25.02.85**

(54) Photovoltaic element.

(30) Priority: **23.02.84 JP 33003/84**

(43) Date of publication of application:
**18.09.85 Bulletin 85/38**

(45) Publication of the grant of the patent:
**10.07.91 Bulletin 91/28**

(84) Designated Contracting States:
**DE FR GB NL**

(56) References cited:
**EP-A- 0 051 980         WO-A-84/02229
DE-A- 3 049 226         FR-A- 2 266 312
US-A- 4 173 497         US-A- 4 358 782**

**PATENTS ABSTRACTS OF JAPAN, vol. 4, no. 83 (E-15) [565], 14th June 1980; & JP - A - 55 48 978 (ASAHI K.K.) 08-04-1980**

**FIFTEENTH IEEE PHOTOVOLTAIC SPECIALISTS CONFERENCE-1981, May 12-15,1981, Kissimmee, Florida, pages 660-665; IEEE, New York, US.; G. CHEEK et al.:"Mis silicon solar cells: potential advantages"**

**CHEMICAL ABSTRACTS, vol. 98, no. 24, 13th June 1983, page 173, abstract no. 201353q, Columbus, Ohio, US; R.J. HOLWILL et al.:**

**"Thin film amorphous silicon solar cells", & COMM. EUR. COMMUNITIES; [REP.] EUR 1982, EUR 8198, 47 pp.**

(73) Proprietor: **CANON KABUSHIKI KAISHA
30-2, 3-chome, Shimomaruko, Ohta-ku
Tokyo(JP)**

Proprietor: **Kanegafuchi Chemical Industry
Co., Ltd.
2-4 Nakanoshima 3-chome
Kita-ku Osaka-shi Osaka-fu(JP)**

(72) Inventor: **Fujiwara, Ryoji
5-23, Ohfune 6-chome
Kamakura-shi Kanagawa-ken(JP)**
Inventor: **Yamaguchi, Minori
5-40, Higashi Hitomaru-cho
Akashi-shi Hyogo-ken(JP)**
Inventor: **Shimizu, Isamu
41-26, Fujigaoka 2-chome Midori-ku
Yokohama-shi Kanagawa-ken(JP)**

(74) Representative: **Beresford, Keith Denis Lewis
et al
BERESFORD & Co. 2-5 Warwick Court High
Holborn
London WC1R 5DJ(GB)**

## Description

This invention relates to a photovoltaic element with a novel structure capable of generating photovoltaic effect with good efficiency by receiving the stimulation from electromagnetic waves such as UV-ray, visible light, IR-ray, particularly the sunlight.

In the prior art, as the photovoltaic element, studies have been made about those employing single crystalline or polycrystalline silicon (written as C-Si), GaAs, InP, CdTe and CuInSe₂, and some of them have been launched to practical application. Particularly, in recent years, hydrogenated amorphous silicon (written as "a-Si:H") is attracting attention as the material for forming a photovoltaic element for the advantage of being capable of p, n control in addition to easy area enlargement due to an amorphous material. The reason why photovoltaic elements employing a-Si:H have actively been studied is that a-Si:H involves inherently various advantages as mentioned below:

(1) Because a-Si:H is amorphous in nature, no selection rule is valid for light absorption and therefore its light absorption coefficient is very great to exhibit sufficient light absorption even with a thickness of about 1/200 of that of conventional C-Si.

(2) Since sufficient light absorption can be exhibited even with a thin thickness, the starting material for preparation of thin film can be small in amount, which will lead to conservation of energy.

(3) P, n control can be accomplished with a relatively simple method. In other words, if a gas such as $PH_3$ or $B_2H_6$ is mixed in the starting $SiH_4$ gas, P or B can sufficiently be incorporated into the thin film during the glow discharge decomposition reaction, whereby a n-type or p-type semiconductor thin film can be formed.

(4) Due to lower production cost and production energy, cost repayment and energy repayment of the photovoltaic element itself can be done within a short period of time, whereafter energy gain will be obtained.

As the structure of the photovoltaic element employing a-Si:H, there are (1) Schottky barrier type, (2) metal/insulating layer/a-Si:H type, (3) p-i-n junction type of a-Si:H, etc. Concerning the former two types, due to utilization of a metal as the surface electrode, light reflectance of the metal is generally large and the quantity of light reaching the semiconductor layer is limited by the species of metal employed and the deposited thickness of the metal to cause lowering of efficiency. Accordingly, one which is now generally developed with good progress is the p-i-n type photovoltaic element of (3). The element structure, including its electrode has been reported variously, typically metal/n-i-p structure/ITO/glass type or ITO/n-i-p structure/metal type. One of the most important tasks for photovoltaic element is improvement of photo electro transducing efficiency. According to the recent report, there appeared a thin film solar battery with an efficiency over 10 %. Such a recent improvement in efficiency may be attributable to removal of the impurity level in the i layer and improvement in spectral sensitivity. By imparting the window effect by use of a-SiC or a-SiN to the light irradiating side of an element, improvement in spectral sensitivity as well as prevention of inverse diffusion of carriers are attempted to be effected. Also, as a means for preventing contamination with an impurity in the i layer, it has been proposed to utilize a three-compartment separation type reaction device, which is now going to be practically applied. While utilization of a-SiC or a-SiN for improvement of spectral sensitivity is a great progress, even use of these as the window layer will make it possible with difficulty to broaden the spectral sensitivity to all the wavelength region of the sunlight or room lamp. In other words, a wide band gap material with no light absorption is ideally desirable as the window layer, but use of a completely transparent film of a-SiC or a-SiN as the window layer has so far resulted in lowering of photo electro transducing efficiency of the element as a whole. Thus, a problem remains in the presently available a-Si:H photovoltaic element with respect to blue sensitivity. Further, for improvement of transducing efficiency of photovoltaic elements, it is also necessary to lower the series resistance of the element. For these reasons, even in the case of a-SiC or a-SiN, in spite of much efforts paid to p, n control and control of optical band gap (Eog) and lowering of resistance, the problems remain to be solved.

## SUMMARY OF THE INVENTION

The present invention has been accomplished in view of the various points as described above and an object of the present invention is to provide a photovoltaic element having a novel structure which has overcome various problems involved in the a-Si:H photovoltaic element of the prior art.

Another object of the present invention is to provide a photovoltaic element which has been dramatically enhanced in photo electro transducing efficiency as compared with the element of the prior art.

Still another object of the present invention is to provide a photovoltaic element which has been devised to be improved in spectral sensitivity.

The present invention concerns an amorphous silicon photovoltaic element comprising an active layer of hydrogenated amorphous silicon which forms, at its light impinging side, a junction with a p-type d-transition metal oxide layer wherein the d-transition metal oxide is selected from the following group:

$NiOx_1$ $(1.0 \leq x_1 \leq 1.5)$

$CrOx_2$ $(1.5 \leq x_2 \leq 2.0)$

$IrOx_3$ $(1.5 \leq x_3 \leq 2.0)$

$CoOx_4$ $(1.0 \leq x_4 \leq 1.5)$

$FeOx_5$ $(1.5 \leq x_5 \leq 2.0)$

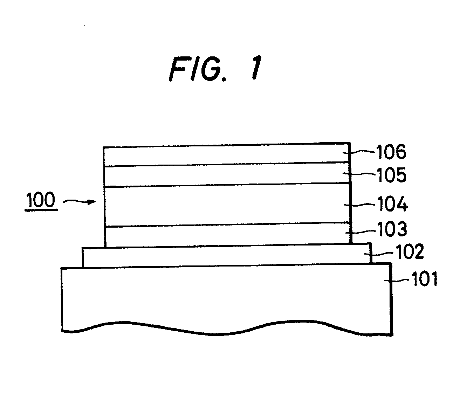

Fig 1 shows schematically a sectional view of the layer constitution of an embodiment of the photovoltaic element of the present invention.

The p-type transition metal oxide constituting the window layer in the photovoltaic element of the present invention, may desirably be of the excessive oxygen type.

In the present invention, effective d-transition metal which can accomplish effectively the objects of the invention may include a metal belonging to the group VI A of the periodic table (Cr), or metals belonging to the group VIII of the periodic table (Ni, Co, Fe, Ir).

Low-oxygen oxides of these metals are colored in black to brown, but sufficient oxidation to the extent of the excessive oxygen type will change the color to pale blue to pale green, whereby it is rendered possible to form a layer to a thickness of 2 nm to 1000 nm (20 Å to 10000 Å), which can transmit the light with a broad range of wavelength from 300 nm to 1000 nm with good efficiency.

We have found that power can be taken out with good efficiency by making a p-i-n type photovoltaic element with a layer structure in which a p-type layer of a p-type transition metal oxide and an active layer of a-Si:H are united. It is believed that the hetero-junction between the p-type layer of the p-type transition metal oxide and the a-Si:H active layer, due to the a-Si:H active layer which is an amorphous layer, is small in distortion at the junction, whereby good running of carriers may be maintained, and also that the ratio of trap recombination of carriers in the p-type layer, the active layer and the interface therebetween can be sufficiently decreased.

Hetero-junctions can also be formed similarly as in the present invention even when a-SiN or a-SiC of the prior art is employed. However, the great difference between the present invention and these prior arts lies in the use of a p-type transition metal oxide containing no Si for the p-type layer. By this, it is rendered possible to obtain a photovoltaic element having the following advantages:

(1) dramatic improvement of light transmittance through the p-type layer as the window layer;

(2) reduction in series resistance; and

(3) high Voc.

The p-type transition metal oxide to be effectively used in the present invention, include $NiOx_1$, $CrOx_2$, $IrOx_3$, $CoOx_4$ and $FeOx_5$.

Ranges of $x_1$ - $x_5$ for accomplishing the objects of the present invention are $1.0 \leq x_1 \leq 1.5$, $1.5 \leq x_2 \leq 2.0$, $1.5 \leq x_3 \leq 2.0$, $1.0 \leq x_4 \leq 1.5$ and $1.5 \leq x_5 \leq 2.0$, respectively.

In the present invention, the p-type transition metal oxide should desirably contain hydrogen atoms, and the content of hydrogen atoms may preferably be 0.01 to 50 atomic %, more preferably 0.1 to 45 atomic % per 1 metal atom.

Referring now to the drawing shown in Fig. 1, an embodiment of the photovoltaic element of the present invention is to be explained in detail.

The photovoltaic element 100 shown in Fig. 1 is constituted of an electroconductive layer 102, a p-type layer 103 of a p-type transition metal oxide, an active layer 104 of an a-Si:H intrinsic semiconductor, a n-type layer 105 of a $n^+$ type a-Si:H and an electrode 106 provided on a substrate 101.

The electroconductive layer 102 is not necessarily required when the substrate 101 is made of an electroconductive material such as metals.

However, when the p-type layer 103 is provided on the side of the substrate 101 relative to the active layer 104, it is desirable to use a substrate made of a material transmissive to light such as glass, transparent ceramics, etc., and therefore an electrode 102 made of a light transmissive electroconductive material is provided on these light transmissive substrates.

Of course, in the case of a photovoltaic element with a layer structure, in which the p-type layer 103 and the n-type layer 105 are reversed in the order laminated with the active layer 104 as the standard, electromagnetic wave for stimulating the active layer 104 is normally irradiated on the side of the electrode 106, and therefore the substrate 101 can be opaque.

The p-type layer of a p-type transition metal oxide can be prepared according to diverse methods, including typically the resistance heating vacuum vapor deposition method, the reactive sputtering method, the electron beam heating vapor deposition method, MOCVD method, etc., and it is possible to select suitable one as desired in conformity with the purpose. More specifically, when the p-type layer of a p-type transition metal oxide is to be prepared, the optimum method may be selected in view of the melting point of its oxide, metal or metal compound, reactivity with oxygen, decomposition rate or other factors, and the electron beam heating vapor deposition method or the reactive sputtering method is preferably employed as the effective method in most cases. The MOCVD (Metal Organic Chemical Vapour Deposition) method is also one of useful methods, because a p-type layer with excellent characteristics can be prepared, although available starting materials are limited.

As an example, referring to the method for preparation of a p-type layer according to the reactive sputtering method, the method for preparation of a photovoltaic element and the element structure are to be explained below.

First, on an electroconductive substrate, a p-type transition metal oxide is deposited. As the electroconductive substrate, there may be employed effectively an opaque material such as aluminium, stainless steel, gold, palladium, copper, copper alloys, silver, etc. or materials to be made translucent to opaque by deposition of these electroconductive materials on an insulating material such as glass or flexible films of heat-resistant polymer films, or transparent electroconductive substrates such as glass/ITO, glass/ITO/$SnO_2$, etc.

For deposition of a p-type transition metal oxide, it is deposited on the above electroconductive substrate while sputtering a metal target (e.g. Ni, Cr, Ir, etc.) in an oxygen atmosphere according to the reactive sputtering method.

The p-type layer should preferably have a thickness preferably of 2 to 500 nm (20 to 5000 Å), more preferably of 2 to 200nm (20 to 2000 Å), most preferably of 5 to 100 nm (50 to 1000 Å). On the p-type layer, an a-Si:H intrinsic semiconductor layer is deposited by, for example, glow discharge decomposition of $SiH_4$, to a thickness preferably of 100 to 2000 nm (1000 to 20000 Å), more preferably of 300 to 1000 nm (3000 to 10000 Å), followed further by deposition of a n-type a-Si:H by, for example, glow discharge decomposition of $SiH_4$ plus $PH_3$, to a thickness preferably of 5 to 200 nm (50 to 2000 Å), more preferably of 10 to 100 nm (100 to 1000 Å), to prepare a photovoltaic element with a p-i-n structure. As the surface electrode, transparent ITO, $SnO_2$ or translucent to opaque metal such as Al, Cr, Pd, Ni, nickel-chromium alloys, copper alloys, etc. may be formed by heating vapor deposition, electron beam heating vapor deposition, sputtering vapor deposition, etc.

The present invention is described in more detail by referring to the following Examples, by which, however, the present invention is not limited at all.

Example 1

As shown in Fig. 1, on a glass substrate 101 coated on its surface with a transparent electroconductive film 102, an iridium oxide film (IrOx) 103 was formed to a thickness of about 0.02 $\mu$m. The iridium oxide film 103 was formed according to the high frequency sputtering method in an oxygen atmosphere by use of a target of metal iridium. The iridium oxide film 103 was prepared under the conditions of a sputtering pressure of 27 Pa, a high frequency power of 0.4 W/cm$^2$ to give a film having the characteristics of a transmittance of 90 % or higher and a DC conductivity of 10 s$\cdot$cm$^{-1}$. As the next step, on the iridium oxide film 103, an intrinsic a-Si:H layer 104 was formed to a thickness of 0.7 $\mu$m by glow discharge decomposition of silane ($SiH_4$), followed by formation of a n$^+$ a-Si:H layer 105 to a thickness of 0.02 $\mu$m by doping with phosphine ($PH_3$) and further by formation of a transparent electroconductive film 106 at the upper portion, to prepare a p-i-n type photovoltaic element 100.

The characteristics of this element under AMl exhibited an open circuit voltage Voc of 0.9 V and a short circuit current Jsc of 15 mA/cm$^2$, with the fill factor FF being 0.7.

Example 2

Example 1 was repeated except that an amorphous chromium trioxide film (a-$Cr_2O_3$) was formed to a thickness of 0.02 $\mu$m in place of the iridium oxide film 102 to prepare a photovoltaic element. The above chromium trioxide film was prepared according to the electron beam vapor deposition method using a pellet prepared by compression molding of $Cr_2O_3$ powder as the vaporization source. The resulting amorphous chromium trioxide film has the characteristics of a transmittance of 75 % and a DC conductivity of 10$^{-5}$S$\cdot$cm$^{-1}$, but further improvements of transmittance and DC conductivity were observed by adding steam during vapor deposition or carrying out reactive ion plating using steam as the reactive gas.

By making the element structure otherwise the same as in Example 1, the characteristics of Voc = 1.5 V, Jsc = 5 mA/cm$^2$ and FF = 0.5 were obtained under irradiation of AMl.

Example 3

A photovoltaic element was prepared according to the same procedure as in Example 1 except for forming a thin nickel oxyhydroxide film [NiOx(OH)y] to a thickness of 0.02 $\mu$m in place of the iridium oxide film. Otherwise, the elemental structure was made the same as that in Example 1. The above thin nickel oxyhydroxide film was prepared according to the reactive ion plating method using a compression molded pellet of powdery nickel oxide (NiO) or metallic nickel pellet as the vaporization source and steam as the reactive gas. The nickel oxyhydroxide film obtained has the characteristics of a transmittance of 95 % and a DC conductivity of 10$^{-4}$S$\cdot$cm$^{-1}$.

The element was found to exhibit FF = 0.4 at Voc = 0.7 V and Jsc = 8 mA/cm$^2$.

Different forms of amorphous silicon would include e.g. amorphous silicon containing carbon atoms, amorphous silicon containing nitrogen atoms and a-SiH (amorphous silicon containing hydrogen atoms).

## Claims

1. An amorphous silicon photovoltaic element comprising an active layer (104) of hydrogenated amorphous silicon which forms, at its light impinging side, a junction with a p-type d-transition metal oxide layer (103) characterised in that the d-transition metal oxide is selected from the following group:
   $NiOx_1$ $(1.0 \leq x_1 \leq 1.5)$
   $CrOx_2$ $(1.5 \leq x_2 \leq 2.0)$
   $IrOx_3$ $(1.5 \leq x_3 \leq 2.0)$
   $CoOx_4$ $(1.0 \leq x_4 \leq 1.5)$
   $FeOx_5$ $(1.5 \leq x_5 \leq 2.0)$.

2. A photovoltaic element according to claim 1, further including a layer (105) of amorphous silicon containing a n-type impurity formed on the active layer (104) at the side thereof opposite to the p-type metal oxide layer (103).

3. A photovoltaic element according to claim 2, wherein the three layers (103,104,105) are formed successively on a substrate.

4. A photovoltaic element according to claim 3, wherein the substrate is flexible.

5. A photovoltaic element according to any preceding claim, wherein the active layer is an intrinsic semiconductor layer.

6. A photovoltaic element according to any preceding claim, wherein the n-type impurity is provided by atoms of an element belonging to group V of the periodic table.

7. A photovoltaic element according to any preceding claim, wherein the d-transition metal belongs to group VI A of the periodic table.

8. A photovoltaic element according to claim 7, wherein the metal belonging to the group VI A of the periodic table is Cr.

9. A photovoltaic element according to any of claims 1 to 6, wherein the d-transition metal belongs to the group VIII of periodic table.

10. A photovoltaic element according to claim 9, wherein the metal belonging to the group VIII of the periodic table is one of Ni, Co, Fe and Ir.

11. A photovoltaic element according to any preceding claim, wherein the p-type transition metal oxide contains hydrogen atoms.

12. A photovoltaic element according to claim 11, wherein the content of hydrogen atoms is from 0.01 atomic % to 50 atomic % per metal atom.

13. A photovoltaic element according to any preceding claim, wherein the p-type layer has a thickness from 2 nm to 500 nm.

14. A photovoltaic element according to any preceding claim, wherein the active layer has a thickness from 100 nm to 2000 nm.

15. A photovoltaic element according to claim 2 or claim 3, or any of claims 4 to 14 as dependent thereon wherein the n-type layer has a thickness of 5 nm to 200 nm.

16. A photovoltaic element according to any preceding claim, including a pair of electrode layers, at least an electrode layer adjacent the p-type layer being transparent or translucent.

## Revendications

1. Elément photovoltaïque en silicium amorphe, comprenant une couche active (104) constituée de silicium amorphe hydrogéné qui forme, du côté de la lumière incidente, une jonction avec une couche d'un oxyde de métal de transition d, de type p, (103), caractérisé en ce que l'oxyde de métal de transition d est choisi dans le Groupe suivant :
   $NiOx_1$ $(1,0 \leq x_1 \leq 1,5)$
   $CrOx_2$ $(1,5 \leq x_2 \leq 2,0)$
   $IrOx_3$ $(1,5 \leq x_3 \leq 2,0)$
   $CoOx_4$ $(1,0 \leq x_4 \leq 1,5)$
   $FeOx_5$ $(1,5 \leq x_5 \leq 2,0)$.

2. Elément photovoltaïque suivant la revendication 1, comprenant en outre une couche (105) de silicium amorphe contenant une impureté de type n formée sur la couche active (104) du côté de cette couche opposé à la couche d'oxyde métallique de type p (103).

3. Elément photovoltaïque suivant la revendication 2, dans lequel les trois couches (103, 104, 105) sont formées successivement sur un substrat.

4. Elément photovoltaïque suivant la revendication 3, dans lequel le substrat est flexible.

5. Elément photovoltaïque suivant l'une quelconque des revendications précédentes, dans lequel la couche active est une couche semiconductrice intrinsèque.

6. Elément photovoltaïque suivant l'une quelconque des revendications précédentes, dans lequel l'impureté de type n est produite par des atomes d'un élément appartenant au Groupe V du Tableau Périodique.

7. Elément photovoltaïque suivant l'une quelconque des revendications précédentes, dans lequel le métal de transition d appartient au Groupe VI A du Tableau Périodique.

8. Elément photovoltaïque suivant la revendication 7, dans lequel le métal appartenant au Groupe VI A du Tableau Périodique est Cr.

9. Elément photovoltaïque suivant l'une quelconque des revendications 1 à 6, dans lequel le métal de transition d appartient au Groupe VIII du Tableau Périodique.

10. Elément photovoltaïque suivant la revendication 9, dans lequel le métal appartenant au Groupe VIII du Tableau Périodique est un métal choisi entre Ni, Co, Fe et Ir.

11. Elément photovoltaïque suivant l'une quelconque des revendications précédentes, dans lequel l'oxyde de métal de transition de type p contient des atomes d'hydrogène.

12. Elément photovoltaïque suivant la revendication 11, dans lequel la teneur en atomes d'hydrogène est comprise dans l'intervalle de 0,01 % atomique à 50 % atomique, par atome de métal.

13. Elément photovoltaïque suivant l'une quelconque des revendications précédentes, dans lequel la couche de type p possède une épaisseur de 2 nm à 500 nm.

14. Elément photovoltaïque suivant l'une quelconque des revendications précédentes, dans lequel la couche active possède une épaisseur de 100 nm à 2000 nm.

15. Elément photovoltaïque suivant la revendication 2 ou la revendication 3, ou bien suivant l'une quelconque des revendications 4 à 14 telles qu'elles en dépendent, dans lequel la couche de type n possède une épaisseur de 5 nm à 200 nm.

16. Elément photovoltaïque suivant l'une quelconque des revendications précédentes, comprenant une paire de couches servant d'électrodes, au moins une couche servant d'électrode adjacente à la couche de type p étant transparente ou translucide.

**Ansprüche**

1. Amorphes Silicium enthaltendes photovoltaisches Element mit einer aktiven Schicht (104) aus hydriertem amorphem Silicium, die an derjenigen ihrer Seiten, auf die Licht auftrifft, einen Übergang mit einer d-Übergangsmetalloxidschicht (103) vom p-Typ bildet, **dadurch gekennzeichnet,** daß das d-Übergangsmetalloxid aus der folgenden Gruppe ausgewählt ist:
$NiOx_1$ $(1,0 \leq x_1 \leq 1,5)$
$CrOx_2$ $(1,5 \leq x_2 \leq 2,0)$
$IrOx_3$ $(1,5 \leq X_3 \leq 2,0)$
$CoOx_4$ $(1,0 \leq x_4 \leq 1,5)$
$FeOx_5$ $(1,5 \leq x_5 \leq 2,0)$.

2. Photovoltaisches Element nach Anspruch 1, das ferner eine Schicht (105) aus amorphem Silicium aufweist, die Störstellen vom n-Typ enthält und auf der Seite der aktiven Schicht (104), die der Metalloxidschicht (103) vom p-Typ entgegengesetzt ist, gebildet ist.

3. Photovoltaisches Element nach Anspruch 2, bei dem die drei Schichten (103, 104, 105) nacheinander auf einem Substrat gebildet sind.

4. Photovoltaisches Element nach Anspruch 3, bei dem das Substrat flexibel ist.

5. Photovoltaisches Element nach einem der vorhergehenden Ansprüche, bei dem die aktive Schicht eine Eigenhalbleiterschicht ist.

6. Photovoltaisches Element nach einem der vorhergehenden Ansprüche, bei dem die Störstellen vom n-Typ durch Atome eines zu der Gruppe V des Periodensystems gehörenden Elements geliefert werden.

7. Photovoltaisches Element nach einem der vorhergehenden Ansprüche, bei dem das d-Übergangsmetall zu der Gruppe VI A des Periodensystems gehört.

8. Photovoltaisches Element nach Anspruch 7, bei dem das Metall das zu der Gruppe VI A des Periodensystems gehört, Cr ist.

9. Photovoltaisches Element nach einem der Ansprüche 1 bis 6, bei dem das d-Übergangsmetall zu der Gruppe VIII des Periodensystems gehört.

10. Photovoltaisches Element nach Anspruch 9, bei dem das Metall, das zu der Gruppe VIII des Periodensystems gehört, eines von Ni, Co, Fe und Ir ist.

11. Photovoltaisches Element nach einem der vorhergehenden Ansprüche, bei dem das Übergangsmetalloxid vom p-Typ Wasserstoffatome enthält.

12. Photovoltaisches Element nach Anspruch 11, bei dem der auf die Metallatome bezogene Gehalt der Wasserstoffatome 0,01 Atom-% bis 50 Atom-% beträgt.

13. Photovoltaisches Element nach einem der vorhergehenden Ansprüche, bei dem die Schicht vom p-Typ eine Dicke von 2 nm bis 500 nm hat.

14. Photovoltaisches Element nach einem der vorhergehenden Ansprüche, bei dem die aktive Schicht eine Dicke von 100 nm bis 2000 nm hat.

15. Photovoltaisches Element nach Anspruch 2 oder 3 oder einem der Ansprüche 4 bis 14, soweit sie davon abhängig sind, bei dem die Schicht vom n-Typ eine Dicke von 5 nm bis 200 nm hat.

16. Photovoltaisches Element nach einem der vorhergehenden Ansprüche, das ein Paar Elektrodenschichten aufweist, wobei wenigstens eine an die Schicht vom p-Typ angrenzende Elektrodenschicht durchsichtig · oder durchscheinend ist.

# FIG. 1